# EUROPEAN PATENT APPLICATION

(11) **EP 3 611 763 A1**
(43) Date of publication of application: **19.02.2020**
(21) Application number: 19191557.8
(22) Date of filing: 13.08.2019
(51) Int. Cl.: H01L 23/552, H01L 25/16, H01L 23/48

(54) **SEMICONDUCTOR DEVICE WITH AN EM-INTEGRATED DAMPER**

(30) Priority: 13.08.2018 US 201862717937 P; 30.07.2019 US 201916526632
(71) Applicant: MediaTek Inc., Hsin-Chu 300 (TW)
(72) Inventor: LIN, Yi-Chieh, 806 Kaohsiung City (TW); LIN, Sheng-Mou, 300 Hsinchu City (TW); WU, Wen-Chou, 300 Hsinchu City (TW)
(74) Representative: Gilani, Anwar

(57) **Abstract**

A semiconductor device includes a first layer structure, a first layer structure, a second layer structure and a passive electronic component. The second layer structure is disposed below the first layer structure and coupled to a ground. The conductive structure is coupled to the first layer structure. The conductive structure is installed vertically between the first layer structure and the second layer structure, and is coupled to a first pad of the second layer structure. The passive electronic component comprises a first terminal coupled to the first pad of the second layer structure and a second terminal coupled to a second pad of the second layer structure. The conductive structure and the passive electronic component are connected in series between the first layer structure and the ground to form a conductive path for conducting at least one electromagnetic interference signal to the ground.

## Description

### BACKGROUND OF THE INVENTION

### Field of the Invention

The invention relates to a semiconductor device with an EM-integrated damper, and more particularly to a semiconductor device with an EM-integrated damper that is capable of improving isolation of the routings in the semiconductor device.

### Description of the Related Art

As technology develops, wireless communication devices such as mobile phones and portable communication devices are becoming more complex. Consumers are demanding smaller devices that provide good reception, a high overall performance, and a wide frequency range. Because interference from different elements may impede or hinder received signals, the arrangement of the elements is crucial to the RF (Radio Frequency, hereafter referred to as RF) signals. In order to avoid, as much as possible, any influence from an adjacent device and also protect the semiconductor device, a common practice is to install a metallic shielding case on the semiconductor device.

However, unwanted cavity resonance also occurs inside a metallic shielding case that is mounted or placed on the printed circuit board (hereinafter referred to as a PCB) or on the substrate. For example, an electromagnetic (hereinafter referred to as EM) field will be generated from the routings or the traces on which the digital (or analog) signals are transmitted, and which becomes unwanted EM interference (hereafter referred to as EMI). The EMI exacerbates the isolation of an RF receiving device and causes the RF sensitivity of the RF receiving device to decrease since reception of the desired RF signal will be impeded by the unwanted EM signal, especially when the resonance frequencies of the EM signal collide with the frequencies of the desired RF signals. Eventually, the desired RF signals cannot be received by the RF receiving device.

To solve this problem, a method for improving isolation of routings of a semiconductor device and a semiconductor device having a novel structure that is capable of improving isolation of the routings are provided.

### BRIEF SUMMARY OF THE INVENTION

Semiconductor devices with EMID are provided.

An exemplary embodiment of a semiconductor device comprises a first layer structure, a conductive structure, a second layer structure and a passive electronic component. The conductive structure is coupled to the first layer structure. The second layer structure is disposed below the first layer structure and coupled to a ground. The passive electronic component is coupled to the second layer structure. The conductive structure is installed vertically between the first layer structure and the second layer structure, and the conductive structure is coupled to a first pad of the second layer structure. The passive electronic component comprises a first terminal coupled to the first pad of the second layer structure and a second terminal coupled to a second pad of the second layer structure. The conductive structure and the passive electronic component are connected in series between the first layer structure and the ground to form a conductive path for conducting at least one electromagnetic interference (EMI) signal to the ground.

The passive electronic component may comprise at least one resistive device.

The passive electronic component may be selected from a group comprising a resistor, a capacitor, an inductor, a transmission line or a combination thereof.

The passive electronic component may be configured to provide a filtering function.

The conductive structure may be a metal shrapnel, a via, a copper pillar or a metal wall.

The semiconductor device may further comprise an aggressor functional block. wherein the conductive structure and the passive electronic component are placed in a radiation path of the aggressor functional block which radiates the EMI signal.

The semiconductor device may further comprise an aggressor functional block, radiating the EMI signal; and a victim functional block, wherein the conductive structure and the passive electronic component are placed in an area between the aggressor functional block and the victim functional block.

The semiconductor device may further comprise a shielding case; and a printed circuit board, wherein the first layer structure is a top portion of the shielding case, and the second layer structure is a portion of the printed circuit board, wherein the shielding case is placed on the printed circuit board, and wherein the conductive structure and the passive electronic component are placed inside of the shielding case.

The conductive structure may be in physical contact with an inner surface of the top portion of the shielding case and extend downward to reach the printed circuit board, and wherein the conductive structure has a length that is long enough for the conductive structure to be capable of being in physical contact with the first pad on the printed circuit board.

The conductive structure may be electrically connected to the first pad and extend upward, and wherein the conductive structure has a length that is long enough for the conductive structure to be capable of being in physical contact with an inner surface of the top portion of the shielding case.

The semiconductor device may further comprise a first semiconductor die; an interposer substrate, wherein the first semiconductor die is mounted on the interposer substrate; a second semiconductor die, disposed below the interposer substrate; and a package substrate, wherein the second semiconductor die is mounted on the package substrate, wherein the first layer structure is a portion of the interposer substrate and the second layer structure is a portion of the package substrate, and wherein the conductive structure and the passive electronic component are placed inside a cavity formed between the interposer substrate and the package substrate.

The conductive structure may be a solder ball electrically connected between the interposer substrate and the package substrate.

The semiconductor device may further comprise a first semiconductor die; an interposer substrate, wherein the first semiconductor die is mounted on the interposer substrate; a second semiconductor die, disposed below the interposer substrate; and a package substrate, wherein the second semiconductor die is mounted on the package substrate, wherein the first layer structure is a portion of the interposer substrate and the second layer structure is a portion of the package substrate, and wherein the conductive structure and the passive electronic component are placed outside a cavity formed between the interposer substrate and the package substrate.

Another exemplary embodiment of a semiconductor device comprises a shielding case, a conductive structure, a printed circuit board and a passive electronic component. The conductive structure is coupled to the shielding case. The printed circuit board is disposed below the shielding case and coupled to a ground. The shielding case is placed on the printed circuit board. The conductive structure is installed vertically between an inner surface of a top portion of the shielding case and the printed circuit board, and is coupled to a first pad of the printed circuit board. The passive electronic component comprises a first terminal coupled to the first pad of the printed circuit board and a second terminal coupled to a second pad of the printed circuit board. The conductive structure and the passive electronic component are connected in series between the top portion of the shielding case and the ground to form a conductive path for conducting at least one EMI signal generated inside of the shielding case to the ground.

The passive electronic component may be selected from a group comprising a resistor, a capacitor, an inductor, a transmission line or a combination thereof, and wherein the conductive structure is a metal shrapnel, a via, a copper pillar or a metal wall.

The conductive structure and the passive electronic component may be placed in a radiation path of an aggressor functional block which radiates the EMI signal.

The conductive structure and the passive electronic component may be placed between an aggressor functional block which radiates the EMI signal and a victim functional block.

Another exemplary embodiment of a semiconductor device comprises a first package assembly comprising an interposer substrate, a second package assembly disposed below the first package assembly and comprising a package substrate, coupled to a ground, a conductive structure coupled to the interposer substrate and a passive electronic component coupled to the package substrate. The conductive structure is installed vertically between the interposer substrate and the package substrate, and the conductive structure is coupled to a first pad of the package substrate. The passive electronic component comprises a first terminal coupled to the first pad of the package substrate and a second terminal coupled to a second pad of the package substrate. The conductive structure and the passive electronic component are connected in series between the interposer substrate and the ground to form a conductive path for conducting at least one electromagnetic interference (EMI) signal to the ground.

The passive electronic component may be selected from a group comprising a resistor, a capacitor, an inductor, a transmission line and a combination of the resistor, the capacitor, the inductor and the transmission line, and wherein the conductive structure is a metal shrapnel, a via, a copper pillar or a metal wall.

The conductive structure and the passive electronic component may be placed inside a cavity formed between the interposer substrate and the package substrate.

The conductive structure and the passive electronic component may be placed in a radiation path of an aggressor functional block which radiates the EMI signal.

A detailed description is given in the following embodiments with reference to the accompanying drawings.

### BRIEF DESCRIPTION OF DRAWINGS

The invention can be more fully understood by reading the subsequent detailed description and examples with references made to the accompanying drawings, wherein:
FIG. 1A is a schematic diagram of showing an exemplary shielding case of a semiconductor device according to an embodiment of the invention;
FIG. 1B is an exemplary diagram showing the measured isolation of routings on the PCB or substrate in different frequencies according to an embodiment of the invention;
FIG. 2A is a schematic diagram showing an exemplary structure of an EM integrated damper (EMID) according to a first embodiment of the invention;
FIG. 2B is an exemplary diagram showing the measured isolation according to the first embodiment of the invention;
FIG. 3A is a schematic diagram showing another exemplary structure of an EMID according to a second embodiment of the invention;
FIG. 3B is an exemplary diagram showing the measured isolation according to the second embodiment of the invention;
FIG. 4 is a schematic diagram showing an exemplary semiconductor device according to an embodiment of the first aspect of the invention;
FIG. 5A is a schematic diagram showing an exemplary semiconductor device according to an embodiment of the second aspect of the invention;
FIG. 5B is a schematic diagram showing another exemplary semiconductor device according to another embodiment of the second aspect of the invention;
FIG. 5C is a schematic diagram showing another exemplary semiconductor device according to another embodiment of the second aspect of the invention;
FIG. 5D is a schematic diagram showing another exemplary semiconductor device according to another embodiment of the second aspect of the invention;
FIG. 6A is a schematic diagram of an exemplary semiconductor device for showing an exemplary area between the aggressor functional block and the victim functional block to place the proposed EMID according to an embodiment of the invention;
FIG. 6B is a schematic diagram of another exemplary semiconductor device for showing another exemplary area between the aggressor functional block and the victim functional block to place the proposed EMID according to another embodiment of the invention; and
FIG. 6C is a schematic diagram of another exemplary semiconductor device for showing another exemplary area between the aggressor functional block and the victim functional block to place the proposed EMID according to another embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

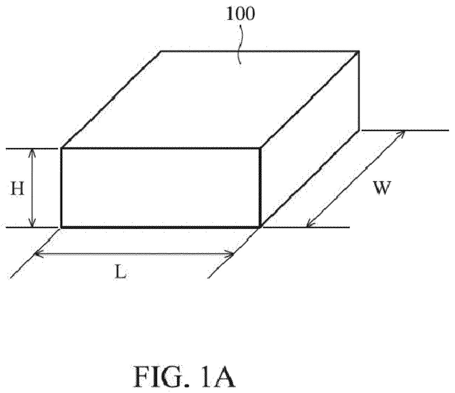

FIG. 1A is a schematic diagram showing an exemplary shielding case of a semiconductor device according to an embodiment of the invention. The shielding case 100 has a length L, a width W and a height H. The shielding case 100 is generally utilized as a substrate cover to protect a semiconductor die, a semiconductor package assembly, an integrated circuit (IC) or a chip. For shielding purposes, the shielding case 100 is generally made of metal. However, the shielding case 100 in combination with the substrate creates a cavity in which cavity resonance can occur. In other embodiment, the substrate could be a PCB in a semiconductor package assembly.

When the operating frequency of a semiconductor device enters into a highfrequency band, such as microwave or millimeter wave bands, the effect of cavity resonance can become a serious problem.

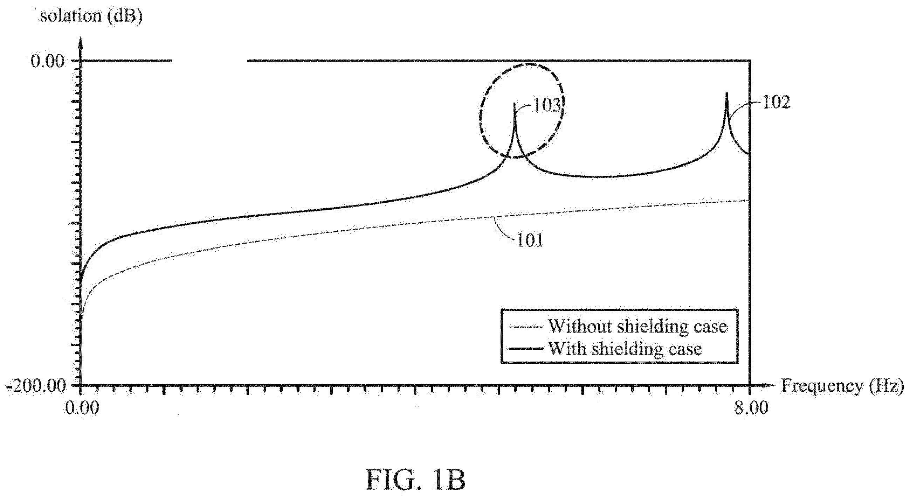

FIG. 1B is an exemplary diagram showing the measured isolation of routings on the substrate in different frequencies according to an embodiment of the invention. The curve 101 is the measured isolation when a substrate is not covered by a shielding case. The curve 102 is the measured isolation when a substrate is covered by a shielding case. As shown in FIG. 1B, the isolation become worse when the shielding case is utilized. In addition, a peak 103 is further generated at the frequency around 5GHz when the shielding case is utilized.

One conventional approach to solve the cavity resonance problem is to change the size of the shielding case, such as the length L, the width W and/or the height H shown in FIG. 1A, since the resonance frequency is related to the length L, the width W and the height H of the shielding case. For example, the resonance frequency may decrease when the size of the shielding case is increased.

However, the substrate size and the package size have to be changed as well when the size of the shielding case is changed. For the increase demand of a small form factor of a wireless communication product, it is really unwanted to further increase the substrate size and the package size just for the purpose to decrease resonance frequency.

To solve this problem, a method for improving isolation of routings, traces, or wirings of a semiconductor device and the semiconductor device having a novel structure that is capable of improving isolation of the routings, traces, or wirings are provided

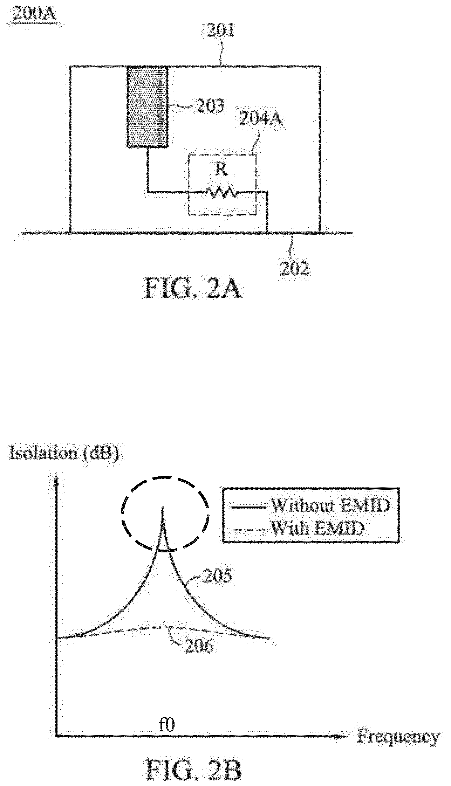

FIG. 2A is a schematic diagram showing an exemplary structure of an EM integrated damper (EMID) according to a first embodiment of the invention.

According to an embodiment of the invention, the semiconductor device 200A may comprise a first layer structure 201, a second layer structure 202, a conductive structure 203 and a passive electronic component 204A. The first layer structure 201 and the second layer structure 202 may extend horizontally. For example, the first layer structure 201 may extend in a first direction D1, the second layer structure 202 may extend in a second direction D2, and the first direction D1 and the second direction D2 are parallel or substantially parallel. The second layer structure 202 is disposed below the first layer structure 201 and coupled to the ground, for example, via the ground pad (not shown in FIG. 2A).

The conductive structure 203 is coupled to the first layer structure 201. The passive electronic component 204A is coupled to the second layer structure 202. The passive electronic component 204A may comprise at least one resistive device, such as the resistor R shown in FIG. 2A.

According to an embodiment of the invention, the conductive structure 203 is installed vertically or substantially vertically between the first layer structure 201 and the second layer structure 202. For example, the conductive structure 203 may extend in a third direction D3 which is perpendicular or substantially perpendicular to the first direction D1 and the second direction D2. In addition, according to an embodiment of the invention, the conductive structure 203 and the passive electronic component 204A are connected in series between the first layer structure 201 and the ground (e.g. a ground pad of the second layer structure 202), so as to form a conductive path with relatively low resistance, for conducting at least one electromagnetic interference (EMI) signal to the ground.

In practice, the conductive structure 203 may be coupled to a first pad (not shown in FIG. 2A) of the second layer structure 202. The passive electronic component 204A comprises a first terminal coupled to the first pad of the second layer structure 202 and a second terminal coupled to a second pad (not shown in FIG. 2A) of the second layer structure 202. The second pad may be a ground pad or may further be coupled to the ground.

In the first embodiment of the invention, the conductive structure 203 and the passive electronic component 204A may form an EMID. According to an embodiment of the invention, the EMID may be installed inside a cavity which is naturally formed in the semiconductor device. However, it should be noted that the invention is not limited to merely installing the EMID inside the cavity. According to another embodiment of the invention, the EMID may also be installed outside a cavity that is formed inside a semiconductor device.

When viewing from another aspect of the invention, in order to absorb the unwanted EMI signal, according to an embodiment of the invention, the EMID may be installed adjacent to or close to an aggressor functional block (such as a semiconductor package assembly, a semiconductor die, an IC, a chip, a system-on-a-chip (SoC) die, an SoC package assembly, or a circuit) which radiates the unwanted EMI signal, installed adjacent to or close to a victim functional block (such as a semiconductor package assembly, a semiconductor die, an IC, a chip, an SoC die, an SoC package assembly, or a circuit) which experiences interference, or otherwise suffers from an unwanted EMI signal, placed in the radiation path of the aggressor functional block which radiates the unwanted EMI signal, or placed in an area that is positioned between the aggressor functional block and the victim functional block (which will be discussed in more details in the following paragraphs).

FIG. 2B is an exemplary diagram showing the measured isolation according to the first embodiment of the invention. The curve 205 is the measured isolation when the proposed EMID is not added. The curve 206 is the measured isolation when the proposed EMID is added. As shown in FIG. 2B, the isolation can be improved when the proposed EMID is added. In addition, the peak generated at the frequency f0 can be eliminated since the proposed EMID forms a relatively low-resistance conductive path to conduct or to attract the unwanted EMI signal to the ground, so as to absorb the energy of the EMI signal and eliminate the energy peak generated at the frequency f0.

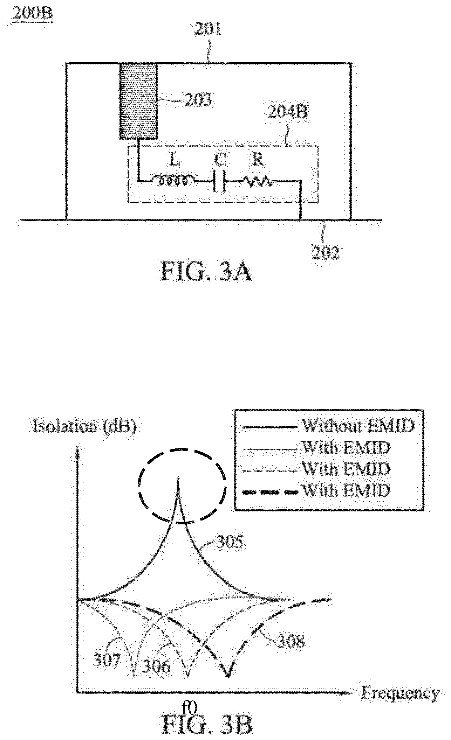

FIG. 3A is a schematic diagram showing another exemplary structure of an EMID according to a second embodiment of the invention.

According to an embodiment of the invention, the semiconductor device 200B may comprise a first layer structure 201, a second layer structure 202, a conductive structure 203 and a passive electronic component 204B. The first layer structure 201 and the second layer structure 202 may extend horizontally. For example, the first layer structure 201 may extend in a first direction D1, the second layer structure 202 may extend in a second direction D2, and the first direction D1 and the second direction D2 are substantially parallel. The second layer structure 202 is disposed below the first layer structure 201 and coupled to the ground, for example, via a ground pad (not shown in FIG. 3A).

The conductive structure 203 is coupled to the first layer structure 201. The passive electronic component 204B is coupled to the second layer structure 202. According to an embodiment of the invention, the passive electronic component 204B may comprise one or more devices which are selected from a group comprising a resistor, a capacitor, an inductor, a transmission line or a combination thereof. For example, in the exemplary embodiment shown in FIG. 3A, the passive electronic component 204B may comprise a resistor R, a capacitor C and an inductor L coupled in series, the combination of which is configured to provide a notch filtering function. In another example, the passive electronic component 204B may be a capacitor C, a resistor R coupled in series, or a transmission line.

According to an embodiment of the invention, the conductive structure 203 is installed vertically or substantially vertically between the first layer structure 201 and the second layer structure 202. For example, the conductive structure 203 may extend along a third direction D3 which is perpendicular or substantially perpendicular to the first direction D1 and the second direction D2. In addition, according to an embodiment of the invention, the conductive structure 203 and the passive electronic component 204B are connected in series between the first layer structure 201 and the ground (e.g. a ground pad of the second layer structure 202), so as to form a conductive path with relatively low resistance, for conducting at least one EMI signal to the ground.

In practice, the conductive structure 203 may be coupled to a first pad (not shown in FIG. 3A) of the second layer structure 202. The passive electronic component 204B comprises a first terminal coupled to the first pad of the second layer structure 202 and a second terminal coupled to a second pad (not shown in FIG. 3A) of the second layer structure 202. The second pad may further be coupled to the ground.

In the second embodiment of the invention, the conductive structure 203 and the passive electronic component 204B may form an EMID. Similarly, according to an embodiment of the invention, the EMID may be installed inside a cavity which is naturally formed in the semiconductor device. However, it should be noted that the invention is not limited to merely installing the EMID inside the cavity. According to another embodiment of the invention, the EMID may also be installed outside a cavity that is formed inside a semiconductor device.

When the invention is viewed from another angle, in order to absorb the unwanted EMI signal, according to an embodiment of the invention, the EMID may be installed adjacent to or close to an aggressor functional block which radiates the unwanted EMI signal, installed adjacent to or close to a victim functional block which experiences interference, or otherwise suffers from an unwanted EMI signal, placed in the radiation path of the aggressor functional block which radiates the unwanted EMI signal, or placed in an area that is positioned between the aggressor functional block and the victim functional block (which will be discussed in more details in the following paragraphs).

FIG. 3B is an exemplary diagram showing the measured isolation according to the second embodiment of the invention. The curve 305 is the measured isolation for scenarios in which the proposed EMID has not been added. The curves 306, 307 and 308 are the measured isolation in scenarios in which the proposed EMID has been added. As shown in FIG. 3B, the isolation can be improved when the proposed EMID is added. In addition, the peak generated at the frequency f0 can be eliminated since the proposed EMID forms a relatively low-resistance conductive path to conduct or to attract the unwanted EMI signal to the ground, so as to absorb the energy of the EMI signal and eliminate the energy peak generated at the frequency f0. In addition, since the proposed EMID in the second embodiment of the invention is configured to provide a notch filtering function, the isolation can be further improved by blocking the EM signal at a predefined frequency. Therefore, comparing to the curve 206 shown in FIG. 2B, at least one notch can be formed in the isolation curves shown in FIG. 3B.

It should be noted that, in the second embodiment of the invention, the EMID is adjustable. That is, by adjusting the corresponding resistance, the capacitance and/or the inductance of the EMID, the frequency at which the isolation has to be greatly improved can be adjusted accordingly. The curves 306, 307 and 308 show the measured isolation with different notch frequencies.

According to an embodiment of the invention, the conductive structure 203 shown in FIG. 2A and FIG. 3A may be a metallic structure, such as a metal shrapnel, a via, a copper pillar or a metal wall. In the embodiments of the invention, the conductive structure 203 may be configured to contribute the inductance. For example, by adequately designing the length of the conductive structure 203, the desired inductance can be provided.

It should be noted that the proposed EMID is also configured to provide coupling suppression using discrete and/or lossy components which are connected between the first layer structure and the second layer structure. For example, for the first embodiment as shown in FIG. 2A, the proposed EMID provides a degeneration path for the cavity resonance from the first layer structure to the second layer structure.. For example, for the second embodiment as shown in FIG. 3A, the proposed EMID provides a high rejection level around LC resonance frequency. It should be noted that, in the other embodiments of the invention, the proposed EMID may also be designed to provide a low pass filtering function or a high pass filtering function. Therefore, the invention should not be limited to the notch filtering function as discussed above.

According to a first aspect of the invention, the first layer structure 201 shown in FIG. 2A and FIG. 3A may be a top portion of a shielding case of a semiconductor device, and the second layer structure 202 shown in FIG. 2A and FIG. 3A may be a portion of the substrate or the PCB of a semiconductor device. It should be noted that, in the embodiments of the first aspect of the invention, the shielding case may be designed for covering the substrate (or, a portion of the PCB) or a semiconductor package assembly.

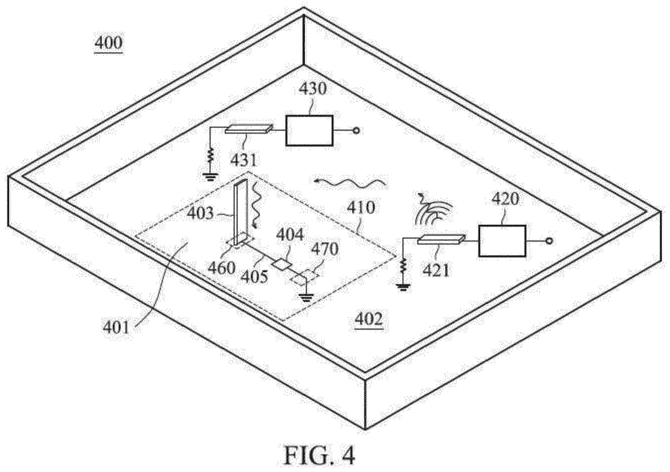

FIG. 4 is a schematic diagram showing an exemplary semiconductor device according to an embodiment of the first aspect of the invention. The semiconductor device 400 may comprise a shielding case 401, a substrate 402 and an EMID 410. It should be noted that, in order to show the components configured inside the shielding case 401, the top portion (e.g., the cover) of the shielding case 401 is shown in a transparent manner. However, as discussed above, in the embodiments of the invention, the shielding case 401 may be made of metal.

The shielding case 401 is a 3-dimential structure or a spatial structure which is hollow and comprises a cave naturally formed inside. The shielding case 401 may comprise a top portion (e.g., the cover) or a top wall and multiple side walls connected to the top wall. The substrate 402 may have a package-attach surface (or, a die-attach surface) facing the inner surface of the top portion or the top wall of the shielding case 401. The shielding case 401 is placed on the substrate 402 with the side walls installed or mounted on the package-attach surface (or, the die-attach surface) of the substrate 402, so as to provide shielding function to cover at least a portion of the substrate 402.

The EMID 410 is placed inside of the shielding case 401 and may comprise a conductive structure 403, such as a vertical metallic structure shown in FIG. 4, and a passive electronic component 404. The EMID 410 may further comprise a trace 405 for electrically connecting the conductive structure 403 and the passive electronic component 404. The conductive structure 403 may be coupled to a first pad (e.g. the pad 460). The passive electronic component 404 comprises a first terminal coupled to the first pad and a second terminal coupled to a second pad (e.g. the pad 470). The second pad may further be coupled to the ground.

According to an embodiment of the invention, the conductive structure 403 (or, the conductive structure 203 shown in FIG. 2A and FIG. 3A) may be designed to be in physical contact with the inner surface of the top portion of the shielding case 401. For example, the conductive structure 403 (or, the conductive structure 203 shown in FIG. 2A and FIG. 3A) may be welded to or formed on the inner surface of the top portion of the shielding case 401. The conductive structure 403 (or, the conductive structure 203 shown in FIG. 2A and FIG. 3A) may extend downward in the direction that is able to reach the substrate 402. The conductive structure 403 (or, the conductive structure 203 shown in FIG. 2A and FIG. 3A) may be designed to have a length that is long enough for the conductive structure 403/203 to be capable of being coupled to, electrically connected to or in physical contact with a first pad (e.g. the pad 460) on the substrate 402.

According to another embodiment of the invention, the conductive structure 403 (or, the conductive structure 203 shown in FIG. 2A and FIG. 3A) may be designed to be electrically connected to a first pad (e.g. the pad 460) on the substrate 402. The conductive structure 403 (or, the conductive structure 203 shown in FIG. 2A and FIG. 3A) may extend upward in the direction that is able to reach the shielding case 401. The conductive structure 403 (or, the conductive structure 203 shown in FIG. 2A and FIG. 3A) may be designed to have a length that is long enough for the conductive structure 403/203 to be capable of being coupled to, electrically connected to or in physical contact with the inner surface of the top portion of the shielding case 401.

According to an embodiment of the invention, the semiconductor device 400 may further comprise functional blocks 420 and 430. The functional block 420 may be an aggressor functional block. The functional block 420 may comprise a digital (or analog) signal processing circuit. The functional block 420 may be coupled to a trace (or, a routing or a wiring) 421 for transmitting digital (or analog) signals. As discussed above, in an embodiment of the invention, an EM field will be generated by the EM signal radiated from the routings or the traces on which the digital (or analog) signals are transmitted, and which becomes an unwanted EMI signal. Therefore, in the embodiment of the invention, the functional block 420 may be the aggressor functional block which radiates the EMI signal as shown in FIG. 4.

The functional block 430 may be a victim functional block which experiences interference, or otherwise suffers from an unwanted EMI signal. As shown in FIG. 4, the EMID 410 may be placed in the radiation path of the aggressor functional block 420, so as to provide a degeneration path toward the ground for degrading the EMI signal. As shown in FIG. 4, the EMID 410 may also be placed in any position in the area between the aggressor functional block 420 and the victim functional block 430. Therefore, the invention should not be limited to the placement shown in FIG. 4. In the embodiments of the invention, the EMID 410 may be placed in any position as long as the unwanted EMI signal generated inside of the shielding case 401 can be degraded, absorbed, or attracted by the EMID 410.

According to a second aspect of the invention, the semiconductor device may also comprise a package on package (POP) structure. The first layer structure 201 shown in FIG. 2A and FIG. 3A may be a portion of an interposer substrate of the POP structure, and the second layer structure 202 shown in FIG. 2A and FIG. 3A may be a portion of the package substrate of the POP structure.

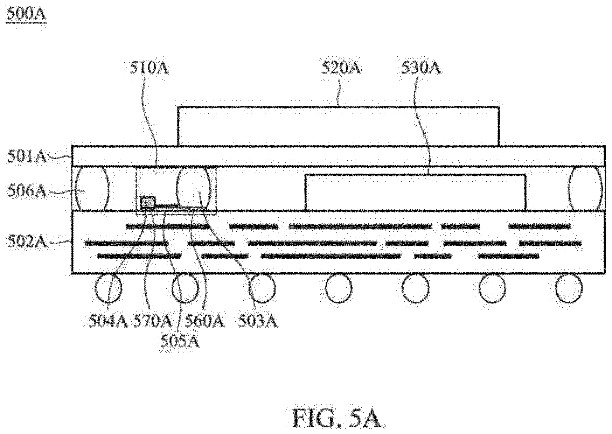

FIG. 5A is a schematic diagram showing an exemplary semiconductor device according to an embodiment of the second aspect of the invention. The semiconductor device 500A may comprise an interposer substrate 501A, a package substrate 502A, semiconductor dies 520A and 530A and the proposed EMID 510A. In the POP structure shown in FIG. 5A, the semiconductor die 520A is packaged in a top package assembly, and the semiconductor die 530A is packaged in a bottom package assembly disposed below the top package assembly. It should be noted that a molding compound is not shown in FIG. 5A.

In other embodiment, the semiconductor die 20a may be mounted on a substrate in the top package assembly and the interposer substrate 501A may be omitted.

The semiconductor die 520A may be mounted on a die-attach surface of the interposer substrate 501A, and may be electrically connected to the interposer substrate 501A. The interposer substrate 501A may be further electrically connected to the package substrate 502A via multiple conductive structures which comprise conductive bump structures such as copper bumps, solder ball structures, solder bump structures, conductive pillar structures, conductive wire structures, or conductive paste structures. For example, the conductive structures may be multiple solder balls, such as solder balls 503A and 506A. The package substrate 502A may further be coupled to the ground via multiple conductive structures as discussed above, such as ground balls.

In this embodiment, a cavity may be formed between the interposer substrate 501A and the package substrate 502A. For example, a cavity, such as the area framed by the dash lines, may be created by the interposer substrate 501A, the package substrate 502A and the solder balls 503A and 506A, and thus, unwanted cavity resonance may also occur in the POP structure. According to an embodiment of the invention, the proposed EMID 510A may be placed inside of the cavity. In this embodiment, the solder ball 503A electrically connected between the interposer substrate 501A and the package substrate 502A may be directly used as the conductive structure of the EMID 510A. The EMID 510A may further comprise a passive electronic component 504A and a trace 505A for electrically connecting the solder ball 503A and the passive electronic component 504A. In the embodiment of the invention, the solder ball 503A may be coupled to a first pad (e.g. the pad 560A) of the package substrate 502A. The passive electronic component 504A comprises a first terminal coupled to the first pad of the package substrate 202A via the trace 505A and a second terminal coupled to a second pad (e.g. the pad 570A) of the package substrate 202A. The second pad may further be coupled to the ground.

According to an embodiment of the invention, the semiconductor die 520A may be an aggressor functional block. For example, the semiconductor die 520A may comprise a digital (or analog) signal processing circuit. The semiconductor die 520A may be coupled to a trace (or, a routing or a wiring) (not shown in FIG. 5A) for transmitting digital (or analog) signals. An EM field will be generated by the EM signal radiated from the routings or the traces when the digital (or analog) signals are being transmitted, and which becomes an unwanted EMI signal. Therefore, in the embodiment of the invention, the semiconductor die 520A may be the aggressor functional block which radiates the EMI signal.

In the embodiment, the semiconductor die 530A mounted on a die-attach surface of the package substrate 502A may be a victim functional block which experiences interference, or otherwise suffers from an unwanted EMI signal. According to an embodiment of the invention, the conductive structure (e.g. the solder ball 503A) and the passive electronic component 504A may be placed in the radiation path of the aggressor semiconductor die 520A, so as to provide a degeneration path toward the ground for degrading the EMI signal. According to another embodiment of the invention, the conductive structure (e.g. the solder ball 503A) and the passive electronic component 504A may also be placed in any position in the area between the aggressor semiconductor die 520A and the victim semiconductor die 530A. In the embodiments of the invention, the EMID may be placed in any position as long as the unwanted EMI signal generated inside of the cavity or inside the POP structure may be degraded, absorbed, or attracted by the EMID.

However, since both the semiconductor die 520A and the semiconductor die 530A perform data transformation, each of the semiconductor die 520A or the semiconductor die 530A could be an aggressor functional block and the other once could be victim functional block and are not limited.

It should be noted that the spatial arrangement of the aggressor functional block, the victim functional block and the proposed EMID is not limited to the embodiment shown in FIG. 5A.

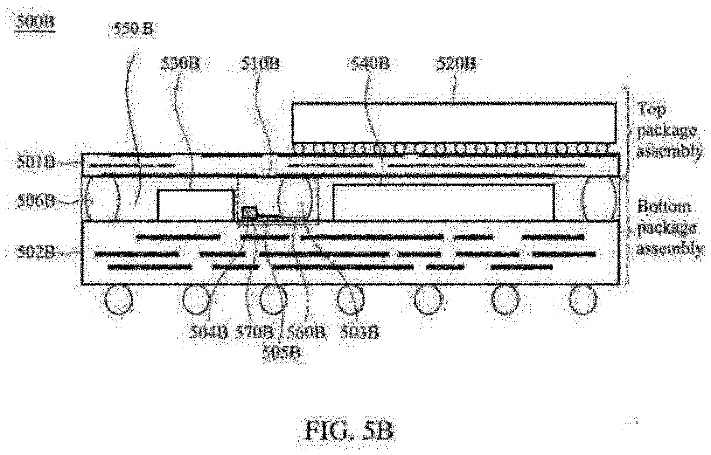

FIG. 5B is a schematic diagram showing another exemplary semiconductor device according to another embodiment of the second aspect of the invention. The semiconductor device 500B may comprise an interposer substrate 501B, a package substrate 502B, semiconductor dies 520B, 530B and 540B, a molding compound 550B and the proposed EMID 510B. In the POP structure shown in FIG. 5B, the semiconductor die 520B and the interposer substrate 501B are packaged in a top package assembly, and the semiconductor dies 530B and 540B and the package substrate 502B are packaged in a bottom package assembly disposed below the top package assembly.

The semiconductor die 520B may be mounted on a die-attach surface of the interposer substrate 501B, and may be electrically connected to the interposer substrate 501B via multiple conductive structures which comprise conductive bump structures such as copper bumps, solder ball structures, solder bump structures, conductive pillar structures, conductive wire structures, or conductive paste structures. The interposer substrate 501B may be further electrically connected to the package substrate 502B via multiple conductive structures as discussed above. For example, the conductive structures connected between the interposer substrate 501B and the package substrate 502B may be multiple solder balls, such as solder balls 503B and 506B. The package substrate 502B may be coupled to the ground via multiple conductive structures as discussed above, such as ground balls.

In this embodiment, a cavity may be formed between the interposer substrate 501B and the package substrate 502B. For example, a cavity may be created by the interposer substrate 501B, the package substrate 502B and the solder balls 503B and 506B, and thus, unwanted cavity resonance may also occur in this POP structure. According to an embodiment of the invention, the proposed EMID 510B may be placed inside of the cavity. In this embodiment, the solder ball 503B electrically connected between the interposer substrate 501B and the package substrate 502B may be directly used as the conductive structure of the EMID 510B. The EMID 510B may further comprise a passive electronic component 504B and a trace 505B for electrically connecting the solder ball 503B and the passive electronic component 504B. The solder ball 503B may be coupled to a first pad (e.g. the pad 560B) of the package substrate 502B. The passive electronic component 504B comprises a first terminal coupled to the first pad of the package substrate 502B via the trace 505B and a second terminal coupled to a second pad (e.g. the pad 570B) of the package substrate 502B. The second pad may further be coupled to the ground.

According to an embodiment of the invention, the semiconductor die 520B may be an aggressor functional block. For example, the semiconductor die 520B may comprise a digital (or analog) signal processing circuit. The semiconductor die 520B may be coupled to a trace (or, a routing or a wiring) (not shown in FIG. 5B) for transmitting digital (or analog) signals. An EM field will be generated by the EM signal radiated from the routings or the traces when the digital (or analog) signals are being transmitted, and which becomes an unwanted EMI signal. Therefore, in the embodiment of the invention, the semiconductor die 520B may be the aggressor functional block which radiates the EMI signal.

In the embodiment, the semiconductor die 530B mounted on a die-attach surface of the package substrate 502B may be a victim functional block which experiences interference, or otherwise suffers from an unwanted EMI signal. According to an embodiment of the invention, the conductive structure (e.g. the solder ball 503B) and the passive electronic component 504B may be placed in the radiation path of the aggressor semiconductor die 520B, so as to provide a degeneration path toward the ground for degrading the EMI signal. According to another embodiment of the invention, the conductive structure (e.g. the solder ball 503B) and the passive electronic component 504B may also be placed in any position in the area between the aggressor semiconductor die 520B and the victim semiconductor die 530B. In the embodiments of the invention, the EMID may be placed in any position as long as the unwanted EMI signal generated inside of the cavity or inside the POP structure may be degraded, absorbed, or attracted by the EMID.

It should be noted that, unlike in FIG. 5A, the vertical projection of the aggressor functional block may not overlap the vertical projection of the victim functional block in this embodiment. It should also be noted that the semiconductor die 540B may also be an aggressor functional block for the semiconductor die 530B, and the EMID 510B may also be utilized to degrade the EMI signal radiated by the corresponding routings or the traces of the semiconductor die 540B.

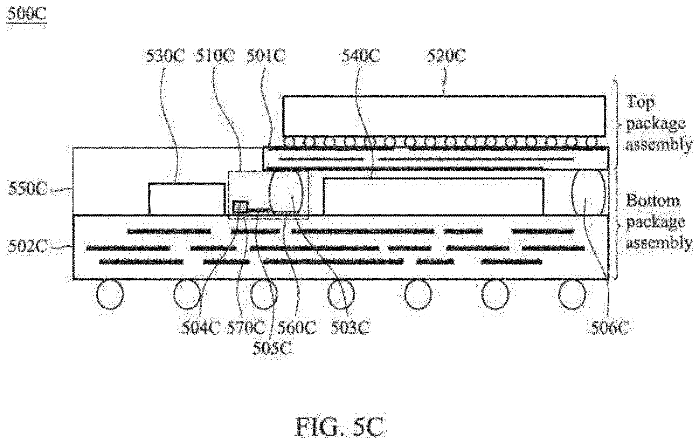

FIG. 5C is a schematic diagram showing another exemplary semiconductor device according to another embodiment of the second aspect of the invention. The semiconductor device 500C may comprise an interposer substrate 501C, a package substrate 502C, semiconductor dies 520C, 530C and 540C, a molding compound 550C and the proposed EMID 510C. In the POP structure shown in FIG. 5C, the semiconductor die 520C and the interposer substrate 501C are packaged in a top package assembly, and the semiconductor die 540C and the package substrate 502C are packaged in a bottom package assembly disposed below the top package assembly.

The semiconductor die 520C may be mounted on a die-attach surface of the interposer substrate 501C, and may be electrically connected to the interposer substrate 501C via multiple conductive structures which comprise conductive bump structures such as copper bumps, solder ball structures, solder bump structures, conductive pillar structures, conductive wire structures, or conductive paste structures. The interposer substrate 501C may be further electrically connected to the package substrate 502C via multiple conductive structures as discussed above. For example, the conductive structures connected between the interposer substrate 501C and the package substrate 502C may be multiple solder balls, such as solder balls 503C and 506C. The package substrate 502C may be coupled to the ground via multiple conductive structures as discussed above, such as ground balls.

In this embodiment, the semiconductor die 520C may be an aggressor functional block. For example, the semiconductor die 520C may comprise a digital (or analog) signal processing circuit. The semiconductor die 520C may be coupled to a trace (or, a routing or a wiring) (not shown in FIG. 5C) for transmitting digital (or analog) signals. An EM field will be generated by the EM signal radiated from the routings or the traces when the digital (or analog) signals are being transmitted, and which becomes an unwanted EMI signal. Therefore, in the embodiment of the invention, the semiconductor die 520C may be the aggressor functional block which radiates the EMI signal.

The semiconductor die 530C mounted on a die-attach surface of the package substrate 502C may be a victim functional block which experiences interference, or otherwise suffers from an unwanted EMI signal. It should be noted that, in this embodiment, the semiconductor die 530C is not covered by the interposer substrate 501C. Therefore, the semiconductor die 530C may not be positioned inside a cavity in the POP structure. However, the semiconductor die 530C may still suffer interference from the unwanted EMI signal.

Therefore, in this embodiment, the proposed EMID 510C may be placed outside of the cavity of the POP structure. In this embodiment, the solder ball 503C electrically connected between the interposer substrate 501C and the package substrate 502C may be directly used as the conductive structure of the EMID 510C. The EMID 510C may further comprise a passive electronic component 504C and a trace 505C for electrically connecting the solder ball 503C and the passive electronic component 504C. The solder ball 503C may be coupled to a first pad (e.g. the pad 560C) of the package substrate 502C. The passive electronic component 504C comprises a first terminal coupled to the first pad of the package substrate 502C via the trace 505C and a second terminal coupled to a second pad (e.g. the pad 570C) of the package substrate 502C. The second pad may further be coupled to the ground.

According to an embodiment of the invention, the conductive structure (e.g. the solder ball 503C) and the passive electronic component 504C may be placed in the radiation path of the aggressor semiconductor die 520C, so as to provide a degeneration path toward the ground for degrading the EMI signal. According to another embodiment of the invention, the conductive structure (e.g. the solder ball 503C) and the passive electronic component 504C may also be placed in any position in the area between the aggressor semiconductor die 520C and the victim semiconductor die 530C. In the embodiments of the invention, the EMID 510C may be placed in any position as long as the unwanted EMI signal generated inside the POP structure may be degraded, absorbed, or attracted by the EMID 510C.

It should be noted that, unlike in FIG. 5A, the vertical projection of the aggressor functional block may not overlap the vertical projection of the victim functional block in this embodiment. It should also be noted that, the semiconductor die 540C may also be an aggressor functional block for the semiconductor die 530C, and the EMID 510C may also be utilized to degrade the EMI signal radiated by the corresponding routings or the traces of the semiconductor die 540C.

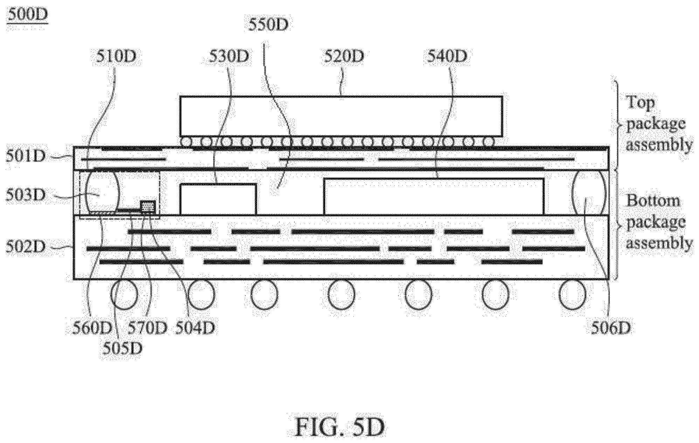

FIG. 5D is a schematic diagram showing another exemplary semiconductor device according to another embodiment of the second aspect of the invention. The semiconductor device 500D may comprise an interposer substrate 501D, a package substrate 502D, semiconductor dies 520D, 530D and 540D, a molding compound 550D and the proposed EMID 510D. In the POP structure shown in FIG. 5D, the semiconductor die 520D and the interposer substrate 501D are packaged in a top package assembly, and the semiconductor die 530D, the semiconductor die 540D and the package substrate 502D are packaged in a bottom package assembly disposed below the top package assembly.

The semiconductor die 520D may be mounted on a die-attach surface of the interposer substrate 501D, and may be electrically connected to the interposer substrate 501D via multiple conductive structures which comprise conductive bump structures such as copper bumps, solder ball structures, solder bump structures, conductive pillar structures, conductive wire structures, or conductive paste structures. The semiconductor die 530D and the semiconductor die 540D may be mounted on a die-attach surface of the package substrate 502D, and may be electrically connected to the interposer substrate 501D via multiple conductive structures as discussed above.

The interposer substrate 501D may be further electrically connected to the package substrate 502D via multiple conductive structures as discussed above. For example, the conductive structures connected between the interposer substrate 501D and the package substrate 502D may be multiple solder balls, such as solder balls 503D and 506D. The package substrate 502D may be coupled to the ground via multiple conductive structures as discussed above, such as ground balls.

In this embodiment, a cavity may be formed between the interposer substrate 501D and the package substrate 502D. For example, a cavity may be created by the interposer substrate 501D, the package substrate 502D and the solder balls 503D and 506D, and thus, unwanted cavity resonance may also occur in this POP structure. According to an embodiment of the invention, the proposed EMID 510D may be placed inside of the cavity. In this embodiment, the solder ball 503D electrically connected between the interposer substrate 501D and the package substrate 502D may be directly used as the conductive structure of the EMID 510D. The EMID 510D may further comprise a passive electronic component 504D and a trace 505D for electrically connecting the solder ball 503D and the passive electronic component 504D. The solder ball 503D may be coupled to a first pad (e.g. the pad 560D) of the package substrate 502D. The passive electronic component 504D comprises a first terminal coupled to the first pad of the package substrate 502D via the trace 505D and a second terminal coupled to a second pad (e.g. the pad 570D) of the package substrate 502D. The second pad may further be coupled to the ground.

In this embodiment, the semiconductor die 520D and/or the semiconductor die 540D may be an aggressor functional block. For example, the semiconductor die 520C/540D may comprise a digital (or analog) signal processing circuit. The semiconductor die 520C/540D may be coupled to a trace (or, a routing or a wiring) (not shown in FIG. 5D) for transmitting digital (or analog) signals. An EM field will be generated by the EM signal radiated from the routings or the traces when the digital (or analog) signals are being transmitted, and which becomes an unwanted EMI signal.

The semiconductor die 530D may be a victim functional block which experiences interference, or otherwise suffers from an unwanted EMI signal generated inside the cavity. According to an embodiment of the invention, the conductive structure (e.g. the solder ball 503D) and the passive electronic component 504D may be placed in the radiation path of the aggressor semiconductor die 520D/540D, so as to provide a degeneration path toward the ground for degrading the EMI signal. According to another embodiment of the invention, the conductive structure (e.g. the solder ball 503D) and the passive electronic component 504D may also be placed in any position in the area between the aggressor semiconductor die 520D/540D and the victim semiconductor die 530D. In the embodiments of the invention, the EMID may be placed in any position as long as the unwanted EMI signal generated inside of the cavity or inside the POP structure may be degraded, absorbed, or attracted by the EMID.

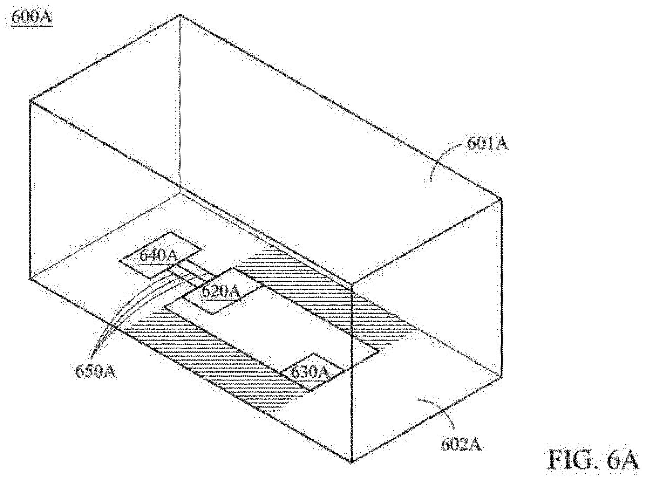

FIG. 6A is a schematic diagram of an exemplary semiconductor device for showing an exemplary area between the aggressor functional block and the victim functional block to place the proposed EMID according to an embodiment of the invention.

In this embodiment, the semiconductor device 600A may comprise a shielding case 601A, a substrate 602A and a semiconductor package. At least two functional blocks 620A and 630A are packaged in the semiconductor package (e.g. a system-on-a-chip (SoC) package) mounted on the substrate 602A. The functional block 620A may be electrically connected to another functional block 640A through the conductive wires 650A. The conductive wires 650A may be the routings or the traces as discussed above on which the digital (or analog) signals are transmitted. The functional block 630A may further be coupled to an off-die component circuit, such as an antenna, through some conductive wires on the substrate 602A. In this embodiment, the functional block 620A is an aggressor functional block and the functional block 630A is a victim functional block. The proposed EMID may be placed in the radiation path of the aggressor functional block which radiates the EMI signal or in an area between the aggressor functional block and the victim functional block as the slashes shown in FIG. 6A.

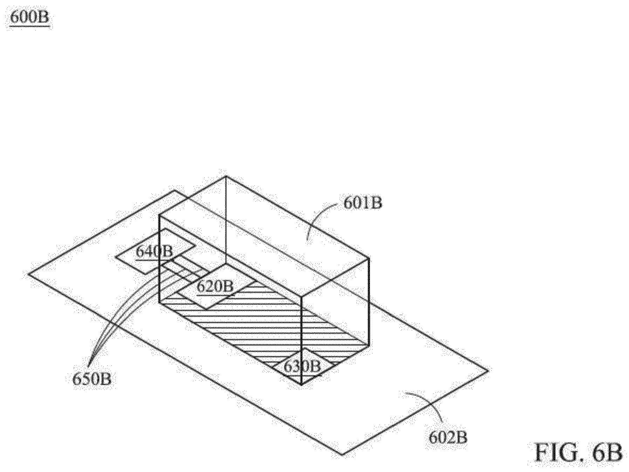

FIG. 6B is a schematic diagram of another exemplary semiconductor device for showing another exemplary area between the aggressor functional block and the victim functional block to place the proposed EMID according to another embodiment of the invention.

In this embodiment, the semiconductor device 600B may comprise a shielding case 601B for shielding a semiconductor package, a substrate 602B and the semiconductor package. The functional blocks 620B and 630B are packaged in the semiconductor package (e.g. a system-on-a-chip (SoC) package) mounted on the substrate 602B, and the shielding case 601B is utilized to cover the overall package. The functional block 620B may be electrically connected to another functional block 640B through the conductive wires 650B. The conductive wires 650B may be the routings or the traces as discussed above on which the digital (or analog) signals are transmitted. The functional block 630B may further be coupled to an off-die component circuit, such as an antenna, through some conductive wires on the substrate 602B. In this embodiment, the functional block 620B is an aggressor functional block and the functional block 630B is a victim functional block. The proposed EMID may be placed inside of the package since the shielding case 601B is now utilized for shielding a semiconductor package, and may be placed in the radiation path of the aggressor functional block which radiates the EMI signal or in an area between the aggressor functional block and the victim functional block as the slashes shown in FIG. 6B.

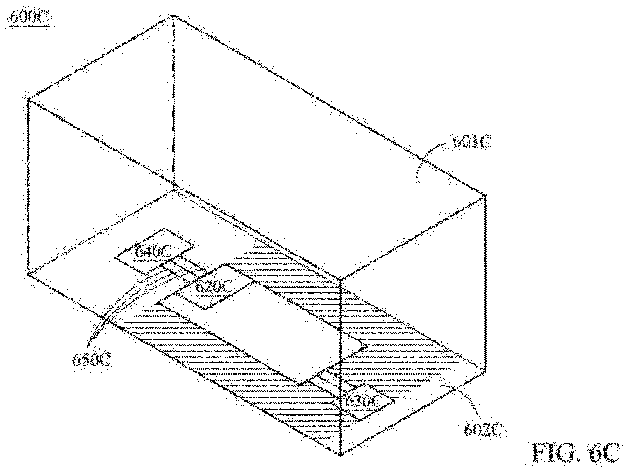

FIG. 6C is a schematic diagram of another exemplary semiconductor device for showing another exemplary area between the aggressor functional block and the victim functional block to place the proposed EMID according to another embodiment of the invention.

In this embodiment, the semiconductor device 600C may comprise a shielding case 601C, a substrate 602C and several semiconductor dies or chips such as the functional blocks 620C, 630C and 640C. The functional block 620C may be electrically connected to another functional block 640C through the conductive wires 650C. The conductive wires 650C may be the routings or the traces as discussed above on which the digital (or analog) signals are transmitted. The functional block 630C may further be coupled to an off-die component circuit, such as an antenna, through some conductive wires on the substrate 602C. In this embodiment, the functional block 620C is an aggressor functional block and the functional block 630C is a victim functional block. The proposed EMID may be placed may be placed in the radiation path of the aggressor functional block which radiates the EMI signal or in an area between the aggressor functional block and the victim functional block as the slashes shown in FIG. 6C.

It should be noted that, when required (such as when there is only a limited amount of free space available for placing the EMID), the proposed EMID may also be placed in any position not covered by the slashes shown in FIG. 6A, FIG. 6B and FIG. 6C, as long as any unwanted EMI signals generated inside of the shielding case 401 can be degraded, absorbed, or attracted by the EMID. In this manner, isolation improvement can still be achieved. For example, the proposed EMID may also be placed between the conductive wires corresponding the aggressor functional block and the conductive wires corresponding to the victim functional block. Therefore, the invention should not be limited to the embodiments discussed above.

It should be noted that, when required (such as when there is more than one unwanted resonance frequency), more than one EMID may be utilized in the semiconductor device. Therefore, the invention should not be limited to the use of only one EMID structure as discussed in the embodiments above.

It should be further noted that, regarding the POP structure, it will be readily appreciated by those who are skilled in this technology that they may deduce the exemplary area between the aggressor functional block and the victim functional block to place the proposed EMID from the embodiments shown in FIG. 5A∼FIG. 5D and FIG. 6A∼FIG. 6C, and therefore, the descriptions are omitted herein for brevity.

As discussed above, in the embodiments of the invention, a novel EMID structure is introduced in a semiconductor device. With the proposed EMID, isolation of the routings, the traces or conductive wires can be improved, and the RF sensitivity of the semiconductor device can be improved as well. In addition, the peak of the degraded isolation generated at a predetermined frequency can be eliminated since the proposed EMID forms a relatively low-resistance conductive path or an energy trap to conduct, absorb or attract the unwanted EMI signal to the ground, so as to absorb the energy of the EMI signal and eliminate the energy peak generated at the predetermined frequency. In addition, since the proposed EMID in the second embodiment of the invention is configured to provide a filtering function, the isolation can be further improved by blocking the EM signal at a predefined frequency. As compared to the conventional approach, the proposed EMID structure is a cost-efficient approach for providing significant isolation improvement without increasing and/or changing the package size, the substrate size and the metallic shielding size.

While the invention has been described by way of example and in terms of preferred embodiment, it is to be understood that the invention is not limited thereto. Those who are skilled in this technology can still make various alterations and modifications without departing from the scope and spirit of this invention. Therefore, the scope of the present invention shall be defined and protected by the following claims and their equivalents.

## Claims

1. A semiconductor device, comprising:
a first layer structure;
a conductive structure, coupled to the first layer structure;
a second layer structure, disposed below the first layer structure and coupled to a ground; and
a passive electronic component, coupled to the second layer structure,
wherein the conductive structure is installed vertically between the first layer structure and the second layer structure, and the conductive structure is coupled to a first pad of the second layer structure,
wherein the passive electronic component comprises a first terminal coupled to the first pad of the second layer structure and a second terminal coupled to a second pad of the second layer structure, and
wherein the conductive structure and the passive electronic component are connected in series between the first layer structure and the ground to form a conductive path for conducting at least one electromagnetic interference (EMI) signal to the ground.

2. The semiconductor device as claimed in claim 1, wherein the passive electronic component comprises at least one resistive device.

3. The semiconductor device as claimed in any preceding claim, wherein the passive electronic component is selected from a group comprising a resistor, a capacitor, an inductor, a transmission line or a combination thereof.

4. The semiconductor device as claimed in any preceding claim, wherein the passive electronic component is configured to provide a filtering function.

5. The semiconductor device as claimed in any preceding claim, wherein the conductive structure is a metal shrapnel, a via, a copper pillar or a metal wall.

6. The semiconductor device as claimed in any preceding claim, further comprising:
an aggressor functional block,
wherein the conductive structure and the passive electronic component are placed in a radiation path of the aggressor functional block which radiates the EMI signal.

7. The semiconductor device as claimed in any preceding claim, further comprising:
an aggressor functional block, radiating the EMI signal; and
a victim functional block,
wherein the conductive structure and the passive electronic component are placed in an area between the aggressor functional block and the victim functional block.

8. The semiconductor device as claimed in any preceding claim, further comprising:
a shielding case; and
a printed circuit board,
wherein the first layer structure is a top portion of the shielding case, and the second layer structure is a portion of the printed circuit board,
wherein the shielding case is placed on the printed circuit board, and
wherein the conductive structure and the passive electronic component are placed inside of the shielding case.

9. The semiconductor device as claimed in claim 8, wherein the conductive structure is in physical contact with an inner surface of the top portion of the shielding case and extends downward to reach the printed circuit board, and wherein the conductive structure has a length that is long enough for the conductive structure to be capable of being in physical contact with the first pad on the printed circuit board.

10. The semiconductor device as claimed in claim 8, wherein the conductive structure is electrically connected to the first pad and extends upward, and wherein the conductive structure has a length that is long enough for the conductive structure to be capable of being in physical contact with an inner surface of the top portion of the shielding case.

11. The semiconductor device as claimed in any of claims 1-7, further comprising:
a first semiconductor die;
an interposer substrate, wherein the first semiconductor die is mounted on the interposer substrate;
a second semiconductor die, disposed below the interposer substrate; and
a package substrate, wherein the second semiconductor die is mounted on the package substrate,
wherein the first layer structure is a portion of the interposer substrate and the second layer structure is a portion of the package substrate, and
wherein the conductive structure and the passive electronic component are placed inside a cavity formed between the interposer substrate and the package substrate.

12. The semiconductor device as claimed in claim 11, wherein the conductive structure is a solder ball electrically connected between the interposer substrate and the package substrate.

13. The semiconductor device as claimed in any of claims 1-7, further comprising:
a first semiconductor die;
an interposer substrate, wherein the first semiconductor die is mounted on the interposer substrate;
a second semiconductor die, disposed below the interposer substrate; and
a package substrate, wherein the second semiconductor die is mounted on the package substrate,
wherein the first layer structure is a portion of the interposer substrate and the second layer structure is a portion of the package substrate, and
wherein the conductive structure and the passive electronic component are placed outside a cavity formed between the interposer substrate and the package substrate.
